# FASCICULE DE BREVET EUROPEEN

(11) **EP 0 887 230 B1**
(45) Date de publication et mention de la délivrance du brevet: **25.07.2001**
(21) Numéro de dépôt: 98111901.9
(22) Date de dépôt: 26.06.1998
(51) Int. Cl.: B60Q 1/14

(54) **Commutateur pour ensemble de commutation de haut de colonne de direction de véhicule automobile**
Lenkstockschalteranordnung für Kraftfahrzeuge
Steering column switching combination for automotive vehicle

(30) Priorité: 27.06.1997 FR 9708096
(43) Date de publication de la demande: 30.12.1998
(73) Titulaire: VALEO ELECTRONIQUE, 94000 Creteil (FR)
(72) Inventeur: Baratay, Hervé, 77400 Lagny sur Marne (FR)
(74) Mandataire: Gamonal, Didier

(56) Documents cités:
- EP-A- 0 768 688
- WO-A-96/23675
- DE-A- 3 532 532

## Description

La présente invention concerne un commutateur pour ensemble de commutation de haut de colonne de direction de véhicule automobile.

De tels ensembles sont connus : ils sont fixés à la colonne de direction et comportent, par exemple, le commutateur d'éclairage et de signalisation et le commutateur de commande d'essuie-vitre et de lave-vitre. L'ensemble de commutation assure la liaison de ces commutateurs par exemple au bus de multiplexage du véhicule.

On connaît également des commutateurs, pour de tels ensembles, qui comprennent un boîtier fermé sur l'un de ses cotés par une platine de fermeture et, à l'intérieur du boîtier, au moins un contact actionnable par une manette de commande pour coopérer avec des pistes formées sur la face interne de la platine de fermeture, voir par exemple le document EP-A-768 688.

Ces commutateurs connus présentent généralement une hauteur relativement élevée, mesurée parallèlement à l'axe de la colonne de direction. En effet, la platine de fermeture sur laquelle sont formées les pistes conductrices, qui s'étend généralement perpendiculairement à l'axe de la colonne de direction, supporte également des composants électroniques qui doivent trouver place entre la platine de fermeture et les dispositifs mécaniques de commutation.

Or, l'encombrement disponible sous le volant dans cette direction est souvent limité. La hauteur du boîtier ne doit pas en effet gêner l'implantation du tube de montage de l'antivol derrière le commutateur, lorsqu'il est vu du conducteur.

La présente invention vise à pallier ces inconvénients et, plus particulièrement, à fournir un commutateur de hauteur réduite.

Selon l'invention, un commutateur, pour ensemble de commutation de haut de colonne de direction de véhicule automobile, comprenant un boîtier fermé sur un de ses cotés par une platine de fermeture et, à l'intérieur du boîtier, au moins un contact actionnable par une manette de commande pour coopérer avec des pistes formées sur la face interne de la platine de fermeture, est caractérisé par le fait que, sur une de ses faces, le boîtier présente au moins une fenêtre au travers de laquelle au moins un contact est agencé pour coopérer, sous l'action de ladite manette de commande, avec des pistes formées directement sur une carte mère, les pistes de la platine de fermeture étant reliées électriquement à un connecteur adapté à coopérer électriquement avec un connecteur porté par ladite carte mère.

Un tel agencement permet de ne plus implanter de composants électroniques sur la platine de fermeture, qui n'assure plus que la fonction de fermeture du boîtier et de support de pistes conductrices. La platine de fermeture peut ainsi se trouver immédiatement en-dessous des organes mécaniques de commutation, ce qui permet de réduire la hauteur du boîtier de commutateur.

Les composants électroniques sont montés directement sur la carte mère, dans la zone où sont formées les pistes coopérant avec les contacts du commutateur.

Avantageusement, ladite face du boîtier comportant ladite fenêtre est la face opposée à la platine de fermeture.

De préférence, la platine de fermeture comporte un rabat sensiblement à 90° muni à son extrémité du connecteur dont les broches sont électriquement reliées aux pistes de la platine de fermeture.

Ces mesures permettent de réaliser un boîtier de commutateur compact, et facile à monter et à connecter à la carte mère.

Plusieurs modes de commande peuvent être envisagés pour les contacts coopérant avec les pistes formées directement sur la carte mère. Ces différents modes peuvent d'ailleurs être combinés entre eux au sein d'un même boîtier de commutateur, de manière à optimiser au mieux le nombre de pièces et de mécanismes de transmission.

Avantageusement, le commutateur comporte un doigt de commande actionné par une bague de la manette de commande et agencé pour coopérer avec une extrémité d'une biellette montée rotative autour d'un axe sensiblement perpendiculaire à ladite face dans laquelle est formée ladite fenêtre, l'autre extrémité de la biellette portant au moins l'un desdits contacts adaptés à coopérer avec les pistes formées directement sur la carte mère ; la biellette est montée rotative sur le boîtier.

Avantageusement, le corps de ladite manette de commande a son extrémité engagée à l'intérieur du boîtier dans un moyeu monté pivotant autour d'un axe perpendiculaire à ladite platine de fermeture, ledit moyeu supportant au moins l'un desdits contacts coopérant avec les pistes formées directement sur la carte mère.

De préférence, le moyeu présente latéralement des ailes bordées extérieurement par une face en secteur cylindrique, à section circulaire centrée sur ledit axe, qui coopère avec une face complémentaire ménagée à l'intérieur du boîtier ; l'extrémité du corps de manette porte deux tourillons engagés dans des trous de pivotement formés dans les ailes du moyeu ; l'extrémité du corps de manette présente un prolongement formant un logement pour un curseur adapté à coopérer avec des pistes de la platine de fermeture.

Avantageusement, la manette de commande porte en bout un bouton poussoir solidaire axialement d'une tige supportant un poussoir portant une lame de contact adaptée à contacter des pistes formées à la surface de la platine de fermeture.

De préférence, le pivotement du corps de manette dans le plan parallèle au volant est indexé dans ses positions stables par un plongeur qui est porté par le moyeu et qui coopère avec des crans d'indexation formés à la surface intérieure du boîtier.

De préférence également, le pivotement du corps de manette dans le plan de la colonne de direction est indexé par deux plongeurs maintenus écartés par un ressort, portés par l'extrémité du corps de manette et coopérant avec des rampes formées à la surface intérieure du moyeu.

Selon un mode particulier d'application, le commutateur est un commutateur de commande d'essuie-vitre.

On décrira maintenant, à titre d'exemple non limitatif, des modes de réalisation particuliers de l'invention, en référence aux dessins schématiques annexés dans lesquels:
- la figure 1 est une vue en perspective éclatée d'un ensemble de commutation de haut de colonne de direction de véhicule automobile, réalisé selon la présente invention ;
- la figure 2 est une vue de face de la carte mère de cet ensemble de commande ;
- la figure 3 est une vue en perspective éclatée du commutateur d'éclairage et de signalisation de l'ensemble de la figure 1 ;
- la figure 4 est une vue de la base de ce commutateur d'éclairage, en coupe selon l'axe de la manette de la figure 3, dans un plan vertical par rapport à cette figure ;
- la figure 5 est une vue en coupe selon la ligne V-V de la figure 4 ;
- la figure 6 est une vue en perspective éclatée du commutateur d'essuie-vitre de l'ensemble de la figure 1 ;
- la figure 7 est une vue en perspective de la base du commutateur d'essuie-vitre de la figure 6 ;
- la figure 8 est une vue en coupe dans le plan VIII-VIII de la figure 7 ;
- la figure 9 est une vue en coupe dans le plan IX-IX de la figure 7 ;
- la figure 10 est une vue en coupe dans le plan X-X de la figure 7 ; et
- la figure 11 est une vue en coupe dans le plan XI-XI de la figure 7.

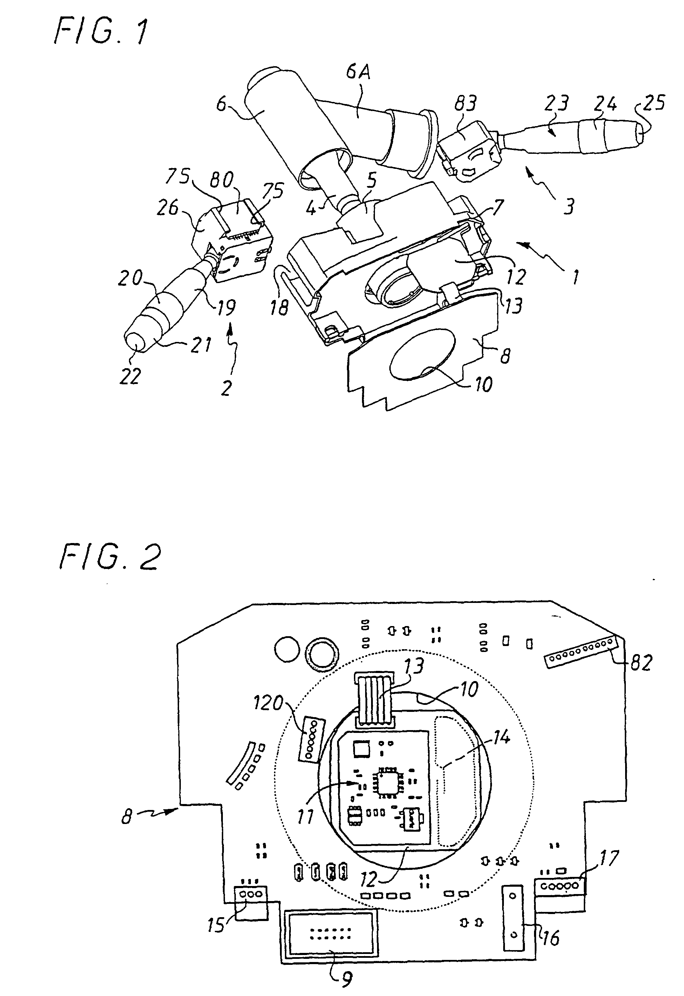

L'ensemble de commutation de la figure 1 comprend d'une manière générale un bloc de support 1 et, montés sur ce bloc de support, un commutateur d'éclairage 2 et un commutateur d'essuie-vitre 3. Le bloc de support 1 est traversé par l'arbre de direction 4 et comporte une douille 5, engagée sur la colonne de direction fixe 6 et fixée à cette dernière par un collier non représenté, en avant du volant. La colonne de direction 6 présente, en arrière du commutateur 3, un tube 6A destiné à recevoir le dispositif antivol.

Le bloc de support 1 est composé pour l'essentiel d'un boîtier 7 dont est solidaire la douille 5, et qui est fermé vers l'arrière (côté conducteur) par un circuit imprimé 8 formant la carte mère de l'ensemble de commutation, fixée par tout moyen convenable. La carte mère 8 est, comme on le verra ci-après, reliée électriquement aux commutateurs d'éclairage 2 et d'essuie-vitre 3. Elle supporte par ailleurs, notamment, un connecteur 9 (figure 2) permettant sa liaison au faisceau électrique du véhicule. On observera ici que les commutateurs 2 et 3 ne commutent que des courants de commande de l'électronique portée par la carte mère 8, donc des courants faibles.

La carte mère 8, figure 2, comporte une découpe 10 circulaire traversée par l'arbre de direction 4. En fait, la carte mère 8 est munie de ses composants avant d'être découpée, et des composants 11 sont montés en particulier sur la partie 12 destinée à être découpée. Cette partie 12 est reliée à sa partie supérieure, également avant découpe, à la partie principale de la carte mère 8, par une nappe de fils 13 assurant la connexion des composants 11.

La partie 12 est ensuite découpée avant le montage de la carte mère 8 sur le bloc de support 1. Lors de ce montage, la partie 12 est elle-même montée sur le bloc de support 1 dans des glissières horizontales, non représentées, au dessus de l'arbre de direction 4.

Les composants 11 montés sur la partie découpée 12 constituent le récepteur radiofréquence de la télécommande d'alarme et de verrouillage des portières du véhicule. Cette partie 12 supporte également l'antenne 14 de ce récepteur, sérigraphiée.

En plus du connecteur 9 précité et des moyens de connexion des commutateurs 2 et 3 qui seront décrits ci-après, la carte mère 8 supporte ici un connecteur 15 pour la commande (non représentée à la figure 1) du récepteur radio, un ronfleur 16 et un connecteur 17 pour un régulateur de vitesse.

Les bases des commutateurs 2 et 3 sont montées à l'intérieur du bloc de support 1 où elles sont fixées par tous moyens convenables. Seules leurs manettes de commande sortent du bloc 1 par des fentes latérales 18.

Extérieurement, la manette de commande du commutateur d'éclairage 2 se compose, d'une part, d'un corps 19, monté rotatif dans un plan parallèle au volant et dans le plan que la manette définit avec la colonne de direction dit plan de la colonne de direction, perpendiculaire au précédent, et, d'autre part, d'une bague rotative médiane 20, d'une bague rotative d'extrémité 21, et d'un bouton poussoir d'extrémité 22.

Dans le plan parallèle au volant, le corps 19 du commutateur 2 possède une position médiane stable avec, de part et d'autre, une position intermédiaire instable et une position d'extrémité stable. La position médiane est neutre, les positions intermédiaires haute et basse correspondent aux clignotants d'autoroute droit et gauche respectivement, et les positions d'extrémité haute et basse correspondent aux clignotants stables droit et gauche.

Dans le plan de la colonne de direction, le corps 19 du commutateur 2 possède une position neutre stable avec, par déplacement vers l'arrière (vers le volant), une première et une deuxième positions instables. La première position instable correspond à l'appel de phares et la deuxième position instable correspond à l'inversion codes/phares.

La bague médiane 20 possède une position neutre stable avec, de part et d'autre, une position instable. Une première impulsion vers la première position instable provoque l'allumage des feux de brouillard avant, et une deuxième impulsion vers cette première position instable provoque en outre l'allumage des feux de brouillard arrière. Une première impulsion vers la deuxième position instable provoque l'extinction des feux de brouillard arrière, et une deuxième impulsion vers cette deuxième position instable provoque l'extinction des feux de brouillard avant.

La bague 21 d'extrémité de manette commande l'éclairage et possède trois positions stables. Une des positions d'extrémité est le neutre (feux éteints), la position médiane sélectionne l'éclairage de ville, et l'autre position d'extrémité sélectionne l'éclairage de route.

Le bouton d'extrémité 22 possède une position stable neutre et, enfoncé, déclenche par exemple l'avertisseur sonore.

La manette du commutateur 3 d'essuie-vitre se compose extérieurement d'un corps de manette 23, rotatif dans un plan parallèle au volant et dans le plan que la manette définit avec la colonne de direction, dit plan de la colonne de direction, d'une bague rotative 24, et d'un bouton poussoir d'extrémité 25.

Dans le plan parallèle au volant, le corps 23 de manette possède une position médiane neutre stable, deux positions instables successives par déplacement vers le bas, deux positions instables successives par déplacement vers le haut et, au delà de ces deux dernières positions, trois positions stables vers le haut. Le déplacement vers le haut vers la première position instable correspond à la mise en fonction de l'essuie-vitre avant par intermittence puis, par impulsions successives, à des vitesses de plus en plus grandes. Le déplacement vers le haut vers la deuxième position instable correspond à la mise en fonction de l'essuie-vitre avant en grande vitesse. La première position stable haute met l'essuie-vitre avant en fonction par intermittence, la deuxième le met en fonction en petite vitesse et la troisième en grande vitesse. Des déplacements successifs vers le bas vers la première position instable entraînent une réduction progressive de la vitesse de fonctionnement de l'essuie-vitre avant, et un déplacement vers le bas vers la deuxième position instable entraîne son arrêt.

Dans le plan de la colonne de direction, le corps 23 du commutateur possède une position neutre stable et une position instable. Le maintien du commutateur en position instable fait fonctionner le lave-vitre avant.

La bague 24 possède deux positions stables et une position instable. Une position stable est la position neutre, et la deuxième position stable est celle de fonctionnement de l'essuie-vitre arrière. Au delà de cette deuxième position stable, la position instable correspond à la mise en fonctionnement du lave-vitre arrière.

L'enfoncement du bouton 25 provoque le défilement des informations de l'ordinateur de bord.

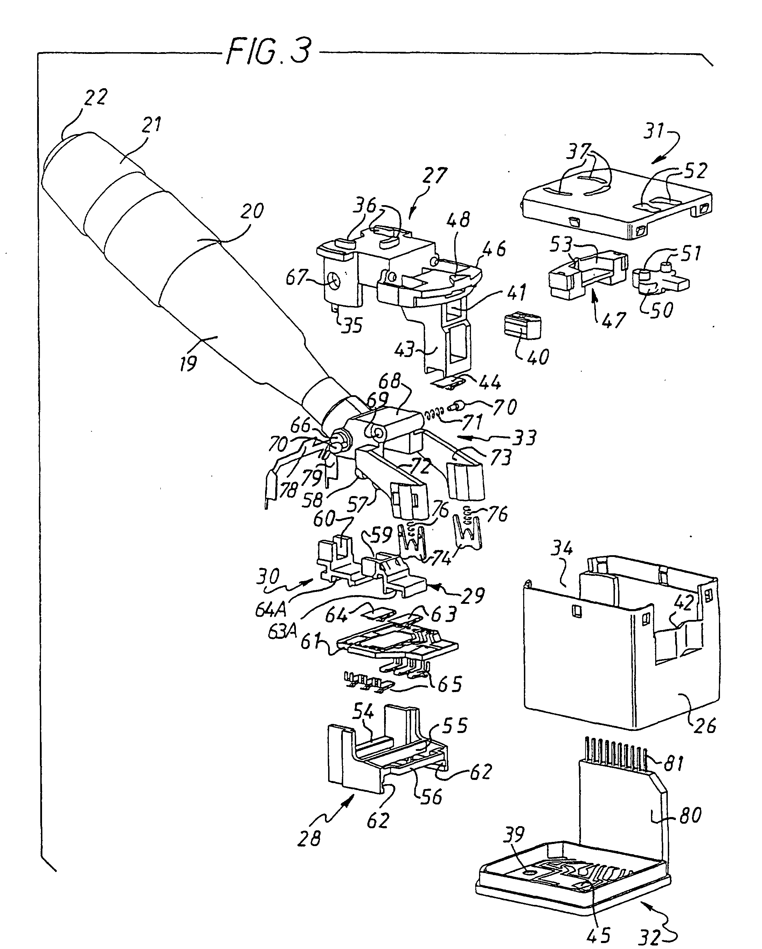

On décrira maintenant en détail la base du commutateur 2 d'éclairage et de signalisation, en référence aux figures 3 à 5. La manette elle-même ne sera pas décrite, étant du type connu ne comportant pas de fil de liaison électrique.

La base du commutateur 2 comprend un boîtier 26 qui contient pour l'essentiel un moyeu 27, un porte-chariots 28, un chariot 29 de sélection d'éclairage route/ville, et un chariot 30 de commande des feux de brouillard. Il est fermé coté volant par un couvercle 31 encliqueté et, coté opposé au volant, par une platine surmoulée 32 emboîtée.

L'extrémité 33 du corps 19 de manette traverse une découpe 34 du boîtier 26 et est engagée dans le moyeu 27.

Le moyeu 27 est monté rotatif dans le boîtier 26 autour d'un axe sensiblement parallèle à l'axe de l'arbre de direction en vue de la commande des clignotants. A cet effet, il possède en partie haute trois bossages 36 en forme de secteurs de cercle engagés dans des fentes 37 de formes correspondantes aménagées dans le couvercle 31. Le porte-chariots 28 est lié en rotation au moyeu 27 grâce à deux pions 35 que comporte le moyeu 27 et qui sont reçus dans deux logements correspondants du porte-chariots 28 ; en variante, cette liaison en rotation peut être obtenue par une complémentarité des formes du moyeu 27 et du porte-chariots 28, l'un s'emboîtant partiellement dans l'autre ; le porte-chariots 28 est muni d'un doigt de pivotement 38 engagé dans un orifice 39 de la platine 32, ce qui conforte le guidage en pivotement de l'ensemble moyeu 27 et porte-chariots 28.

Le pivotement du moyeu 27 et du porte-chariots 28 est commandé par la rotation du corps 19 de manette dans le plan parallèle au volant. Son indexation dans ses trois positions stables est obtenue par un plongeur 40, monté coulissant dans un logement 41 du moyeu 27 et pressé par un ressort non représenté vers des crans 42 formés à la surface intérieure du boîtier en vis à vis de la découpe 34.

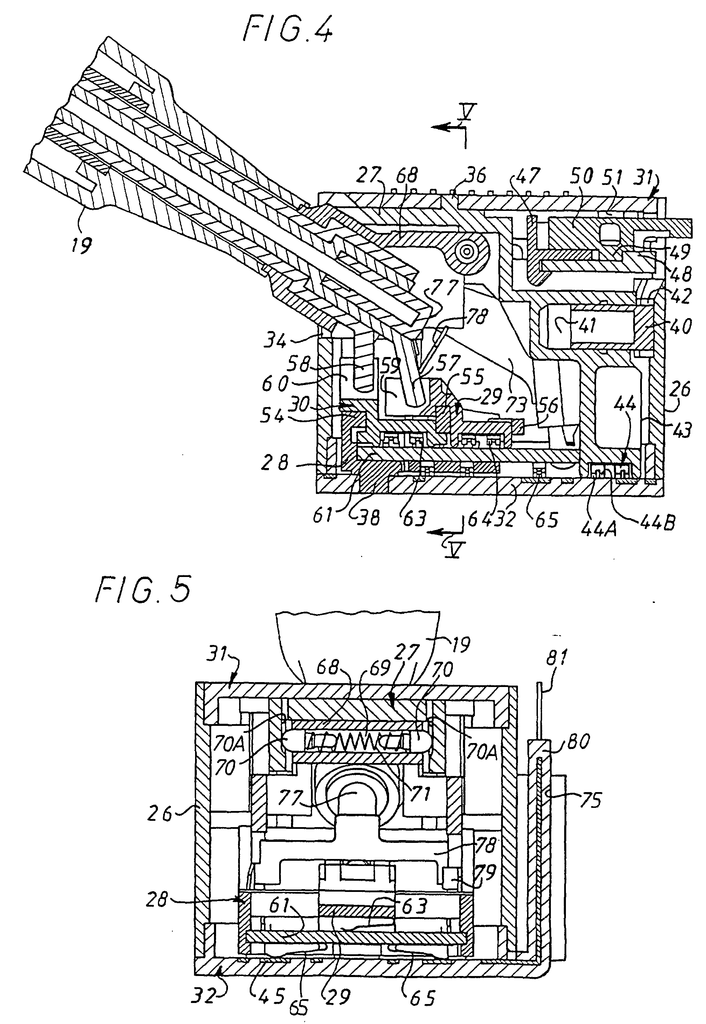

La partie inférieure 43 du moyeu 27 maintient et manoeuvre un curseur 44 qui coopère avec des pistes d'un circuit 45 formé à la surface interne de la platine 32 ; avantageusement, le curseur 44 est double, c'est-à-dire qu'il présente deux têtes de contact 44A, 44B, figure 4, pour assurer la fiabilité du contact électrique : ceci est d'ailleurs vrai également pour les autres curseurs décrits ci-après.

La partie supérieure 46 du moyeu 27 porte un tiroir 47 d'indicateur de direction, agencé pour assurer la fonction de rappel automatique de la manette de clignotant d'une position indexée à sa position centrale pour une rotation du volant dans le sens inverse de la direction indiquée.

A cet effet, la face supérieure du moyeu 27 forme une came 48 en V, constituant des rampes, sur laquelle vient s'appuyer et coulisser un tourillon 49 (figure 4) porté par un doigt de rappel 50. Dans la position neutre de la manette, le tourillon 49 se trouve sur l'arête de la came 48, sur laquelle il est plaqué par un ressort non représenté. Lorsque la manette est actionnée vers une de ses positions indexées, le tourillon 49 glisse sur une des rampes de la came 48 et le doigt de rappel 50 sort en direction de l'axe de la colonne de direction, comme montré à la figure 4.

Le doigt 50 porte par ailleurs deux pivots supérieurs 51 engagés dans des rainures 52 du couvercle 31. Lors de la rotation du volant en sens inverse de la direction indiquée, un organe de rappel porté par l'arbre de direction vient en contact avec l'extrémité sortie du doigt de rappel 50. L'effort appliqué fait pivoter le doigt de rappel 50, dont la partie arrière vient s'appuyer sur les pentes latérales 53 du tiroir 47. Le couple alors créé entre les pivots supérieurs 51, calés dans les rainures 52, et les pentes 53 du tiroir 47, fait sortir le plongeur 40 de son cran 42 d'indexage et la manette du commutateur 2 revient à sa position centrale.

Si la manette est maintenue volontairement à sa position indexée alors que le volant est ramené en sens inverse de la direction indiquée, des ressorts non représentés, situés derrière le tiroir 47, fléchissent de sorte que le tiroir 47 recule en permettant ainsi le passage de l'organe de rappel de l'arbre de direction, toute dégradation étant ainsi évitée.

Le porte-chariots 28 supporte les chariots 29 et 30 de façon coulissante verticalement parallèlement à la platine 32, c'est-à-dire globalement verticalement lorsque le commutateur est monté sur le véhicule. A cet effet, il possède trois barres de guidage parallèles, deux barres de guidage d'extrémité 54 et 56 et une barre de guidage intermédiaire 55 ; chacun des chariots 29 et 30 coopère en guidage avec une barre de guidage d'extrémité et la barre de guidage intermédiaire, et son guidage est ainsi parfaitement assuré ; ici, le chariot 29 coopère avec la barre de guidage d'extrémité 56 et la barre de guidage intermédiaire 55, et le chariot 30 avec cette même barre de guidage intermédiaire 55 et la barre de guidage d'extrémité 54.

Les chariots 29 et 30 sont mus sur le porte-chariots 28 par des doigts 57 et 58, engagés dans des logements 59 et 60 des chariots et commandés respectivement par les bagues 21 et 20 de la manette.

Le porte-chariots 28 supporte par ailleurs un circuit imprimé de sélection 61, dans deux glissières 62 situées sous les barres 54, 55 et 56, parallèlement à la platine 32. Les pistes de ce circuit imprimé 61 coopèrent avec deux curseurs de sélection 63 et 64. Le curseur 63 est maintenu dans un logement 63A que présente le chariot 29 de sélection route/ville et est manoeuvré par celui-ci ; le curseur 64 est maintenu dans un logement 64A que présente le chariot 30 de feux de brouillard et est manoeuvré par celui-ci. La liaison électrique entre le circuit imprimé de sélection 61 et le circuit 45 de la platine 32 est assurée par des curseurs de liaison 65 soudés sur la face inférieure du circuit imprimé de sélection 61.

Cet agencement, comprenant le circuit imprimé de sélection 61 solidaire du porte-chariots 28 et du moyeu 27, et les curseurs de liaison 65 entre le circuit imprimé de sélection 61 et le circuit 45, évite de perturber le positionnement des chariots 29 et 30 sur les pistes du circuit imprimé de sélection 61 lors de la mise en fonction des clignotants.

Le corps 19 de manette est muni de deux pivots 66 d'axe vertical engagés dans des trous 67 du moyeu 27. La manette peut ainsi pivoter dans le plan de la colonne de direction pour assurer les fonctions d'appel de phares et d'inversion codes/phares. L'extrémité du corps 19 de manette possède par ailleurs, au delà des pivots 66, un prolongement 68 dans lequel un perçage 69 reçoit deux plongeurs 70 tenus écartés l'un de l'autre par un ressort 71. Les plongeurs 70 coopèrent avec des pentes 70A prévues sur le moyeu 27 pour fournir les deux courses successives assurant les deux fonctions ci-dessus.

L'extrémité du corps 19 de manette se termine par deux bras 72 et 73. Chaque bras 72, 73 porte un curseur 74. Ces deux curseurs 74 sont pressés vers le bas par des ressorts 76, en direction des pistes du circuit 45. Les deux bras 72 et 73 sont décalés en hauteur de manière que les curseurs 74 entrent successivement en contact avec leurs pistes respectives pour assurer d'abord la fonction d'appel de phares après la première course, puis la fonction d'inversion codes/phares après la deuxième course. La mémorisation des fonctions est assurée par l'électronique.

Le bouton poussoir 22 en bout de manette est solidaire d'un doigt 77, figure 4, d'actionnement d'avertisseur sonore. Le doigt 77 est en vis-à-vis d'une lame de contact 78 susceptible de fléchir sous sa poussée. Dans ce cas, la lame 78 vient contacter une sortie de lame 79 en assurant la continuité électrique.

La lame 78 et la sortie de lame 79 sont liées électriquement au circuit imprimé de sélection 61 et donc supportées par le porte-chariots 28. La fonction d'avertisseur n'est donc pas perturbée lors de l'utilisation des clignotants.

La platine 32 est solidaire d'un rabat 80 à 90° portant à son extrémité des broches de connexion 81 reliées électriquement aux pistes du circuit 45. Le rabat 80 prend place dans des glissières 75, mieux visibles sur la figure 1, que présente le boîtier 26 sur sa face latérale correspondante ; lorsque le commutateur est en place, le rabat 80 est en position haute et les broches 81 sont engagées dans un connecteur 82 porté par la carte mère 8.

Le fonctionnement du commutateur 2 d'éclairage et de signalisation résulte de la description qui vient d'en être faite ; on rappellera simplement que l'agencement est tel que les fonctions réalisées par rotation du corps 19 de manette dans le plan parallèle au volant ne risquent pas de perturber les autres fonctions grâce à la liaison en rotation du moyeu 27 et du porte-chariots 28, lesquels sont montés à pivotement sur le boîtier 26, le porte-chariots 28 par l'intermédiaire de la platine 32 et le moyeu 27 par l'intermédiaire du couvercle 31.

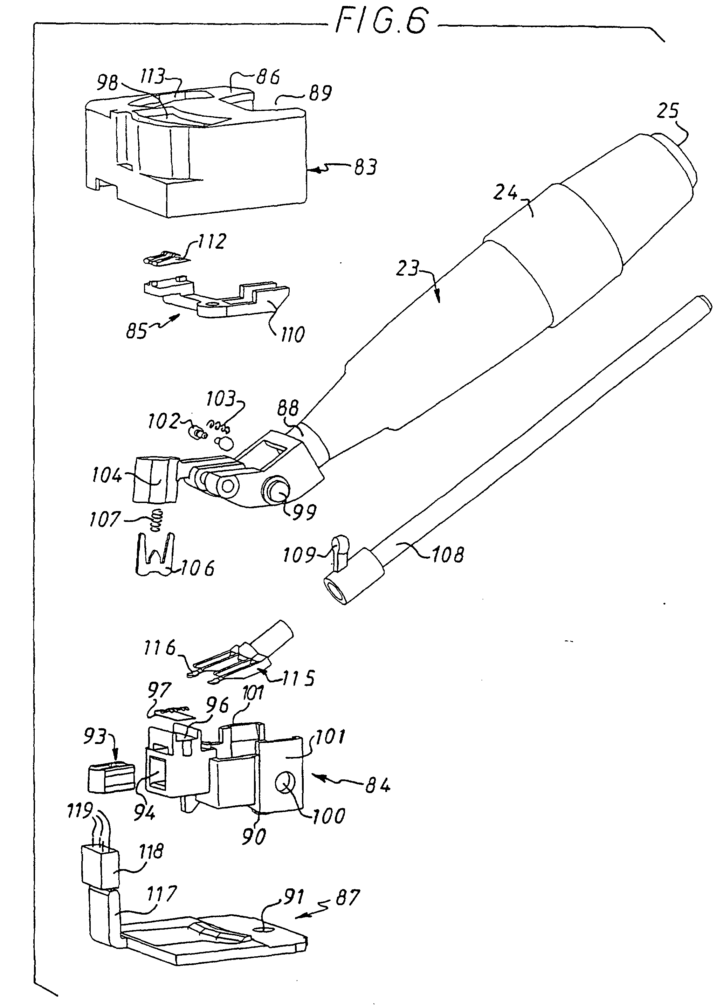

On décrira maintenant la base du commutateur 3 d'essuie-vitre en référence aux figures 6 à 11. Ici non plus, on ne décrira pas la manette elle-même du commutateur, qui est de type connu.

La base du commutateur 3 comprend un boîtier 83 qui contient essentiellement un moyeu 84 et une biellette 85 d'essuie-vitre arrière. Le boîtier 83 est partiellement fermé coté volant par un dessus 86 réalisé d'une seule pièce avec lui et, du coté opposé, par une platine surmoulée 87 emboîtée. L'extrémité 88 du corps 23 de manette traverse une découpe 89 du boîtier et est engagée dans le moyeu 84.

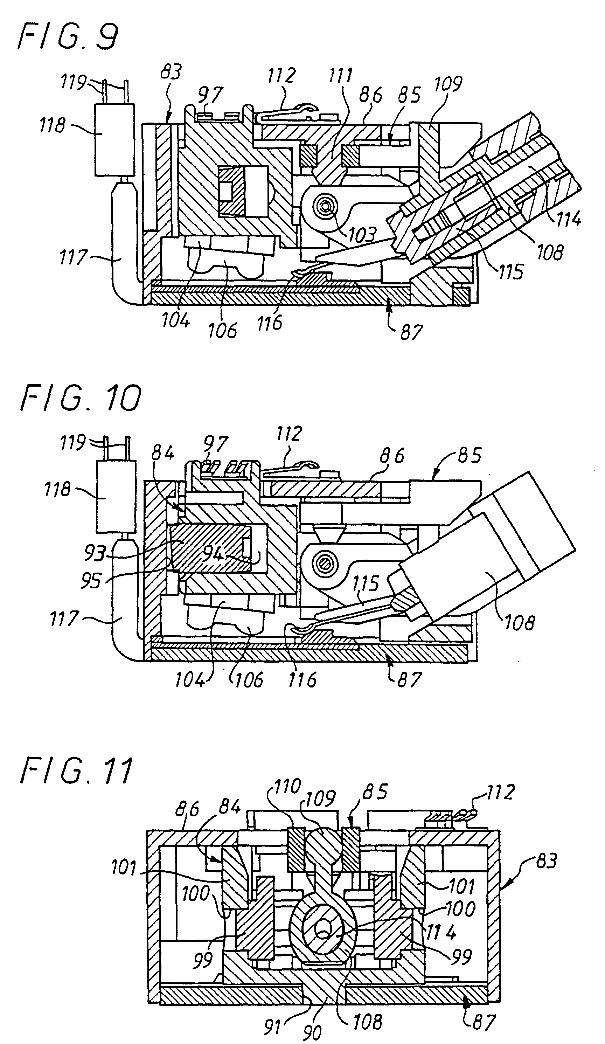

Le moyeu 84 est monté pivotant dans le boîtier 83, autour d'un axe parallèle à l'axe de la colonne de direction, en vue de la commande de l'essuie-vitre avant. A cet effet, il est muni en partie basse d'un tourillon 90 engagé dans un trou 91 formé dans la platine 87, figure 11 ; par ailleurs, le moyeu 84 présente latéralement des ailes 101 bordées extérieurement par une face en secteur cylindrique, à section circulaire centrée sur l'axe du tourillon 90 et du trou 91, qui coopère avec une face complémentaire 92 ménagée à l'intérieur du boîtier 83 : ainsi, le pivotement du moyeu 84 dans le boîtier 83 est parfaitement assuré.

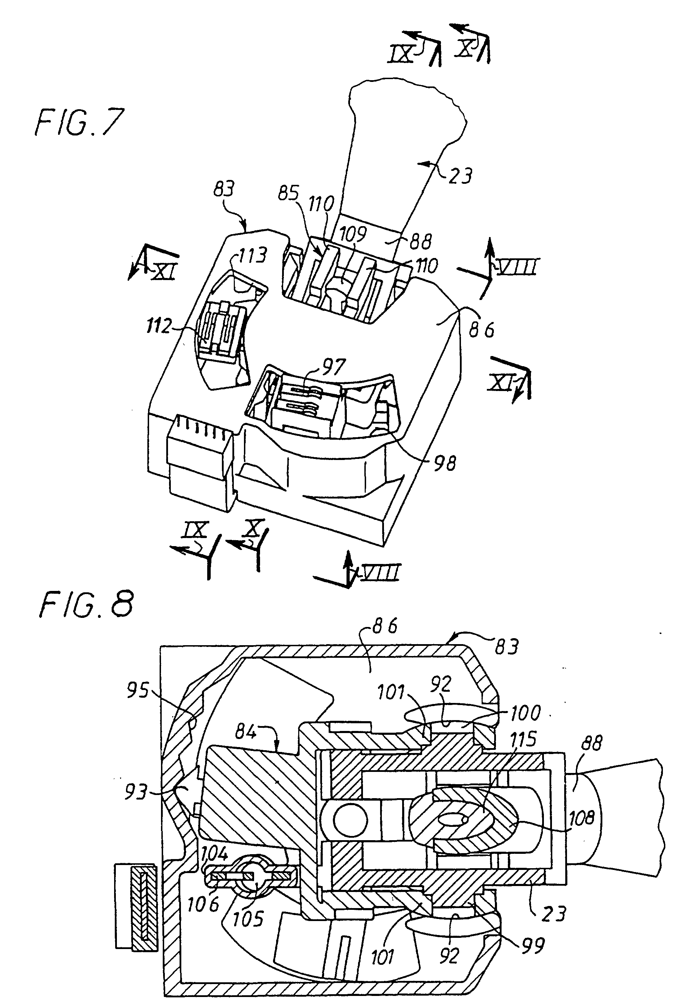

Le pivotement du moyeu 84 est commandé par la rotation du corps 23 de manette dans le plan parallèle au volant. Son indexation dans ses quatre positions stables est obtenue par un plongeur 93, disposé dans un logement 94 du moyeu 84 et pressé par un ressort non représenté en direction de crans d'indexation 95, figure 8, formés à la surface intérieure du boîtier 83.

La face supérieure du moyeu 84 comporte un logement 96 pour maintenir et manoeuvrer un contact 97. Le contact 97 coopère avec des pistes directement tracées sur la carte mère 8. A cet effet, le dessus 86 du moyeu 84 comporte une première fenêtre 98 découpée en vis-à-vis du trajet de déplacement du contact 97, lequel fait saillie à l'extérieur du boîtier 83.

L'extrémité du corps 23 de manette porte deux tourillons 99 engagés dans des trous de pivotement 100 formés dans les ailes 101 du moyeu 84. Il est ainsi susceptible de pivoter vers l'arrière dans le plan de la colonne de direction en vue de la commande du lave-vitre avant. Son indexation dans ce mouvement est réalisée par deux plongeurs 102, logés dans des trous formés à l'extrémité du corps 23 de manette et maintenus écartés par un ressort 103. Ces plongeurs 102 coopèrent avec des rampes formées à la surface intérieure du moyeu 84.

Un prolongement 104 de l'extrémité du corps 23 de manette forme un logement 105 pour un curseur 106 et son ressort 107, figures 6 et 7. Lorsque la manette du commutateur 3 est manoeuvrée vers l'arrière dans le plan de la colonne de direction, elle pivote donc autour des tourillons 99 de sorte que le curseur 106 vient shunter deux pistes sur la platine surmoulée 87, faisant ainsi fonctionner le lave-vitre avant, et ceci quelle que soit la position de la manette pour les fonctions de l'essuie-vitre avant.

Un autre curseur opposé au curseur 106 pourrait coopérer avec des pistes formées sur la carte mère 8 pour actionner un lave-vitre arrière par une manoeuvre de la manette vers l'avant.

La bague 24 de la manette est solidaire en rotation d'une tige 108 creuse qui pivote dans le corps 23 de manette. La tige 108 porte à son extrémité un doigt 109 de commande de l'essuie-vitre arrière. Le doigt 109 est disposé entre deux ailes 110 de la biellette 85. Cette biellette 85 est montée en rotation autour d'un pivot 111 issu du dessus 86 du boîtier 83 et perpendiculaire audit dessus 86.

Plus précisément, la biellette 85 comporte deux bras se raccordant sensiblement perpendiculairement au niveau de son axe de rotation. L'un des bras porte les deux ailes 110 de la biellette 85 et l'autre bras supporte et manoeuvre un contact d'essuie-vitre arrière 112. Le contact 112 coopère directement avec des pistes de la carte mère 8, en faisant saillie à l'extérieur du boîtier 83 à travers une deuxième fenêtre 113 découpée dans le dessus 86 du boîtier 83. L'amplification de mouvement créée par la biellette 85 permet d'obtenir l'écartement voulu entre les zones de contact sur la carte mère 8.

Le bouton poussoir 25 est solidaire axialement d'une tige 114 montée coulissante dans le corps 23 de manette, plus précisément à l'intérieur de la tige 108. Un poussoir 115 est emmanché à l'extrémité de cette tige 114, et porte une lame de contact 116 à deux bras. Lors de l'enfoncement du bouton poussoir 25, la lame 116 vient contacter des pistes formées à la surface de la platine surmoulée 87 et provoquer le défilement des informations affichées par l'ordinateur de bord.

La platine 87 est solidaire d'un rabat 117 à 90° portant à son extrémité un connecteur 118 à broches 119. Les broches 119 sont électriquement reliées aux pistes de la platine 87. Lorsque le commutateur 3 est monté sur le bloc de support 1, le connecteur 118 s'engage dans un connecteur 120 monté sur la carte mère 8, visible sur la figure 1, assurant ainsi la liaison à cette dernière des pistes de la platine 87.

Le fonctionnement du commutateur 3 d'essuie-vitre résulte de la description qui vient d'en être faite ; on rappellera simplement que l'agencement est tel que les fonctions réalisées par rotation du corps 23 de manette dans le plan parallèle au volant ne risquent pas de perturber les fonctions réalisées par rotation du corps 23 de manette dans le plan de la colonne de direction : en effet, les premières mettent en oeuvre des organes, biellette 85 et moyeu 84, portés par le boîtier 83 sur lequel ils sont montés tournant, tandis que les secondes mettent en oeuvre des organes portés par l'extrémité 88 du corps 23 de manette monté articulé sur le moyeu 84 autour d'un axe orthogonal par rapport à celui du moyeu 84.

On a décrit, ci-dessus, un commutateur 2 d'éclairage et signalisation et un commutateur d'essuie-vitre 3 ; bien entendu, tout ou partie des caractéristiques décrites à propos du commutateur 2 d'éclairage et signalisation pourraient être utilisées pour la réalisation d'un commutateur d'essuie-vitre ; de même, tout ou partie des caractéristiques décrites à propos du commutateur d'essuie-vitre 3 pourraient être utilisées pour la réalisation d'un commutateur d'éclairage et signalisation.

On appréciera que le boîtier 83 du commutateur d'essui-vitre 3 est fermé par une seule pièce, à savoir la platine surmoulée 87. Ainsi qu'il ressort à l'évidence de la description et des dessins, les rabats 117, 80 des platines 87, 32 permettent une réduction de l'encombrement parallèlement à la colonne de direction 6. La localisation de l'antenne 14 est favorable puisqu'elle est localisée dans la partie haute du bloc support 1, au dessus de l'arbre de direction 4, en sorte que la réception est bonne, sachant que le bloc support 1 est en matière plastique moulable et électriquement isolante.

Il en est de même de la majeure partie des pièces des commutateurs 2 et 3, à l'exception des curseurs, des pistes électriques, des ressorts, des broches, et de toute autre partie électriquement conductrice.

Tout cela est bien connu, la technique de moulage étant économique et permettant d'obtenir des formes compliquées.

Ainsi, les boîtiers 26, 83, les corps de manettes 19, 23, les moyeux 27, 84, les platines 32, 87, les plongeurs, les chariots 29, 30, le porte chariot 28, le tiroir 47, le doigt 50, la biellette 85, les rabats 80, 117, les bras 42, 73 et les prolongements 68, 104 sont en matière plastique moulable et électriquement isolante.

On notera que les chariots 29, 30 comportent des rainures (non référencées) pour leur montage sur les barrettes 54, 55.

## Revendications

1. Commutateur, pour ensemble de commutation de haut de colonne de direction de véhicule automobile, comprenant un boîtier (83) fermé sur un de ses cotés par une platine (87) de fermeture et, à l'intérieur du boîtier (83), au moins un contact (106,116) actionnable par une manette de commande pour coopérer avec des pistes formées sur la face interne de la platine (87) de fermeture, caractérisé par le fait que, sur une (86) de ses faces, le boîtier (83) présente au moins une fenêtre (98,113) au travers de laquelle au moins un contact (97,112) est agencé pour coopérer, sous l'action de ladite manette de commande, avec des pistes formées directement sur une carte mère (8), les pistes de la platine (87) de fermeture étant reliées électriquement à un connecteur (118) adapté à coopérer électriquement avec un connecteur (120) porté par ladite carte mère (8).

2. Commutateur selon la revendication 1, caractérisé par le fait que ladite face (86) du boîtier (83) comportant ladite fenêtre (98, 113) est la face opposée à la platine (87) de fermeture.

3. Commutateur selon l'une des revendications 1 ou 2, caractérisé par le fait que la platine (87) de fermeture comporte un rabat (117) sensiblement à 90° muni à son extrémité du connecteur (118), dont les broches (119) sont électriquement reliées aux pistes de la platine (87) de fermeture.

4. Commutateur selon l'une quelconque des revendications 1 à 3, caractérisé par le fait qu'il comporte un doigt de commande (109) actionné par une bague (24) de la manette de commande et agencé pour coopérer avec une extrémité d'une biellette (85) montée rotative autour d'un axe (111) sensiblement perpendiculaire à ladite face (86) dans laquelle est formée ladite fenêtre (98, 113), l'autre extrémité de la biellette (85) portant au moins l'un (112) desdits contacts adaptés à coopérer avec les pistes formées directement sur la carte mère (8).

5. Commutateur selon la revendication 4, caractérisé par le fait que la biellette (85) est montée rotative sur le boîtier (83).

6. Commutateur selon l'une quelconque des revendications 2 à 5, caractérisé par le fait que le corps (23) de ladite manette de commande a son extrémité engagée à l'intérieur du boîtier (83) dans un moyeu (84) monté pivotant autour d'un axe (90) perpendiculaire à ladite platine (87) de fermeture, ledit moyeu (84) supportant au moins l'un (97) desdits contacts coopérant avec les pistes formées directement sur la carte mère (8).

7. Commutateur selon la revendication 6, caractérisé par le fait que le moyeu (84) présente latéralement des ailes (101) bordées extérieurement par une face en secteur cylindrique, à section circulaire centrée sur ledit axe (90), qui coopère avec une face complémentaire (92) ménagée à l'intérieur du boîtier (83).

8. Commutateur selon la revendication 7, caractérisé par le fait que l'extrémité du corps (23) de manette porte deux tourillons (99) engagés dans des trous de pivotement (100) formés dans les ailes (101) du moyeu (84).

9. Commutateur selon la revendication 8, caractérisé par le fait que l'extrémité du corps (23) de manette présente un prolongement (104) formant un logement (105) pour un curseur (106) adapté à coopérer avec des pistes de la platine (87) de fermeture.

10. Commutateur selon l'une des revendications 1 à 9, caractérisé par le fait que la manette de commande porte en bout un bouton poussoir (25) solidaire axialement d'une tige (114) supportant un poussoir (115) portant une lame de contact (116) adaptée à contacter des pistes formées à la surface de la platine (87) de fermeture.

11. Commutateur selon l'une des revendications 6 à 9, caractérisé par le fait que le pivotement du corps (23) de manette dans le plan parallèle au volant est indexé dans ses positions stables par un plongeur (93) qui est porté par le moyeu (84) et qui coopère avec des crans d'indexation (95) formés à la surface intérieure du boîtier (83).

12. Commutateur selon l'une des revendications 6 à 9, caractérisé par le fait que le pivotement du corps (23) de manette dans le plan de la colonne de direction est indexé par deux plongeurs (102) maintenus écartés par un ressort (103), portés par l'extrémité du corps (23) de manette et coopérant avec des rampes formées à la surface intérieure du moyeu (84).

13. Commutateur selon l'une des revendications 1 à 12, caractérisé par le fait que c'est un commutateur de commande d'essuie-vitre.

## Claims

1. A switch for a motor vehicle steering column switching complex, comprising a housing (83) closed on one of its sides by a closure plate (87), and, within the housing (83), at least one contact (106, 116) arranged to be actuated by a control stalk for cooperation with tracks formed on the internal face of the closure plate (87), characterised by the fact that, on one of its faces (86), the housing (83) has at least one window (98, 113) through which at least one contact (97, 112) is arranged to cooperate, under the action of the said control stalk, with tracks formed directly on a mother board (8), the tracks of the closure plate (87) being connected electrically to a connector (118) which is adapted for electrical cooperation with a connector (120) carried by the said mother board (8).

2. A switch according to Claim 1, characterised by the fact that the said face (86) of the housing (83) having the said window (98, 113) is the face opposed to the closure plate (87).

3. A switch according to Claim 1 or Claim 2, characterised by the fact that the closure plate (87) includes a portion (117) bent back substantially at 90° and carrying at its end the connector (118), the pins (119) of which are connected electrically to the tracks of the closure plate (87).

4. A switch according to any one of Claims 1 to 3, characterised by the fact that it includes a control finger (119) actuated by a sleeve (24) of the control stalk and arranged to cooperate with one end of a crank (85) which is mounted for rotation about a pivot (111) which is substantially at right angles to the said face (86) in which the said window (98, 113) is formed, the other end of the crank (85) carrying at least one (112) of the said contacts adapted to cooperate with the tracks formed directly on the mother board (8).

5. A switch according to Claim 4, characterised by the fact that the crank (85) is rotatable on the housing (83).

6. A switch according to any one of Claims 2 to 5, characterised by the fact that the body (23) of the said control stalk has its end engaged, within the housing (83), in a hub (84) pivotable about a pivot (90) at right angles to the said closure plate (87), the said hub (84) supporting at least one (97) of the said contacts which cooperate with the tracks formed directly on the mother board (8).

7. A switch according to Claim 6, characterised by the fact that the hub (84) has lateral wing portions (101) which are bounded on the outside by a face in the form of a cylindrical sector with a circular cross section centred on the said pivot (90), which co-operates with a complementary face (92) formed on the inside of the housing (83).

8. A switch according to Claim 7, characterised by the fact that the end of the stalk body (23) carries two bosses (99) engaged in pivot holes (100) formed in the wing portions (101) of the hub (84).

9. A switch according to Claim 8, characterised by the fact that the end of the stalk body (23) has an extension (104) defining a seating (105) for a cursor (106) which is adapted to cooperate with tracks of the closure plate (87).

10. A switch according to one of Claims 1 to 9, characterised by the fact that the control stalk carries at its end a push button (25) fixed axially to a rod (114) that supports a push member (115), which carries a contact leaf (116) adapted to make contact with tracks formed on the surface of the closure plate (87).

11. A switch according to one of Claims 6 to 9, characterised by the fact that the pivoting of the stalk body (23) in the plane parallel to the steering wheel is indexed into its stable positions by a plunger (93) which is carried by the hub (84), and which co-operates with indexing nibs (95) formed on the inside surface of the housing (83).

12. A switch according to one of Claims 6 to 9, characterised by the fact that the pivoting of the stalk body (23) in the plane of the steering column is indexed by two plungers (102) which are held apart by a spring (103) and which are carried by the end of the stalk body (23) for co-operation with ramps formed on the inside surface of the hub (84).

13. A switch according to one of Claims 1 to 12, characterised by the fact that it is a windscreen wiper control switch.

## Patentansprüche

1. Schalter für eine Schalteinheit am oberen Ende der Lenksäule eines Kraftfahrzeugs, umfassend ein Gehäuse (83), das auf einer seiner Seiten durch eine Verschlußplatte (87) verschlossen ist, und im Innern des Gehäuses (83) wenigstens einen Kontakt (106, 116), der durch einen Betätigungshebel betätigt werden kann, um mit Leiterbahnen zusammenzuwirken, die auf der Innenfläche der Verschlußplatte (87) ausgebildet sind, **dadurch gekennzeichnet**, daß das Gehäuse (83) auf einer (86) seiner Flächen wenigstens ein Fenster (98, 113) aufweist, durch das hindurch wenigstens ein Kontakt (97, 112) angeordnet ist, um unter der Einwirkung des besagten Betätigungshebels mit direkt auf einer Mutterplatine (8) ausgebildeten Leiterbahnen zusammenzuwirken, wobei die Leiterbahnen der Verschlußplatte (87) elektrisch mit einem Verbinder (118) verbunden sind, der elektrisch mit einem auf der besagten Mutterplatine (8) angebrachten Verbinder (120) zusammenwirken kann.

2. Schalter nach Anspruch 1, **dadurch gekennzeichnet**, daß die besagte Fläche (86) des Gehäuses (83), die das besagte Fenster (98, 113) enthält, die der Verschlußplatte (87) gegenüberliegende Fläche ist.

3. Schalter nach einem der Ansprüche 1 oder 2, **dadurch gekennzeichnet**, daß die Verschlußplatte (87) eine Umbiegung (117) mit einem Winkel von etwa 90° umfaßt, die an ihrem Ende mit dem Verbinder (118) versehen ist, dessen Stifte (119) elektrisch mit den Leiterbahnen der Verschlußplatte (87) verbunden sind.

4. Schalter nach einem der Ansprüche 1 bis 3, **dadurch gekennzeichnet**, daß er einen Betätigungsfinger (109) umfaßt, der durch einen Ring (24) des Betätigungshebels betätigt wird und so angeordnet ist, daß er mit einem Ende einer Gelenkstange (85) zusammenwirkt, die drehbar um eine Achse (111) gelagert ist, die in etwa senkrecht zu der besagten Flächen (86) verläuft, in der das besagte Fenster (98, 113) eingearbeitet ist, während das andere Ende der Gelenkstange (85) wenigstens einen (112) der besagten Kontakte trägt, die mit den direkt auf der Mutterplatine (8) ausgebildeten Leiterbahnen zusammenwirken können.

5. Schalter nach Anspruch 4, **dadurch gekennzeichnet**, daß die Gelenkstange (85) drehbar am Gehäuse (83) gelagert ist.

6. Schalter nach einem der Ansprüche 2 bis 5, **dadurch gekennzeichnet**, daß der Körper (23) des besagten Betätigungshebels mit seinem Ende im Innern des Gehäuses (83) in eine Nabe (84) eingesetzt ist, die drehbar um eine zu der besagten Verschlußplatte (87) senkrechten Achse (90) gelagert ist, wobei die besagte Nabe (84) wenigstens einen (97) der besagten Kontakte trägt, die mit den direkt auf der Mutterplatine (8) ausgebildeten Leiterbahnen zusammenwirken.

7. Schalter nach Anspruch 6, **dadurch gekennzeichnet**, daß die Nabe (84) seitlich Flügel (101) aufweist, die außen durch eine auf die besagte Achse (90) zentrierte, als Zylindersektor ausgeführte Fläche mit kreisförmigem Querschnitt eingefaßt sind, die mit einer im Innern des Gehäuses (83) ausgebildeten formschlüssigen Fläche zusammenwirkt.

8. Schalter nach Anspruch 7, **dadurch gekennzeichnet**, daß das Ende des Hebelkörpers (23) zwei Lagerzapfen (99) trägt, die in Drehlöchern (100) eingesetzt sind, die in den Flügeln (101) der Nabe (84) ausgebildet sind.

9. Schalter nach Anspruch 8, **dadurch** gekennzeichnet, daß das Ende des Hebelkörpers (23) eine Verlängerung (104) aufweist, die eine Aufnahme (105) für einen Gleitkontakt (106) bildet, der mit Leiterbahnen der Verschlußplatte (87) zusammenwirken kann.

10. Schalter nach einem der Ansprüche 1 bis 9, **dadurch gekennzeichnet**, daß der Betätigungshebel endseitig einen Druckknopf (25) trägt, der axial fest mit einem Schaft (114) verbunden ist, der einen Schieber (115) mit einer daran angebrachten Kontaktleiste (116) trägt, die mit auf der Oberfläche der Verschlußplatte (87) ausgebildeten Leiterbahnen zusammenwirken kann.

11. Schalter nach einem der Ansprüche 6 bis 9, **dadurch gekennzeichnet**, daß die Drehung des Hebelkörpers (23) in der zum Lenkrad parallelen Ebene in ihren stabilen Positionen durch einen Stößel (93) vorpositioniert ist, der an der Nabe (84) angebracht ist und der mit an der Innenfläche des Gehäuses (83) ausgebildeten Vorpositionierrasten (95) zusammenwirken kann.

12. Schalter nach einem der Ansprüche 6 bis 9, **dadurch gekennzeichnet**, daß die Drehung des Hebelkörpers (23) in der Ebene der Lenksäule durch zwei Stößel (102) vorposition iert ist, die durch eine Feder (103) zueinander beabstandet gehalten werden, die am Ende des Hebelkörpers (23) angebracht sind und die mit an der Innenfläche der Nabe (84) ausgebildeten Rampen zusammenwirken.

13. Schalter nach einem der Ansprüche 1 bis 12, **dadurch gekennzeichnet**, daß es sich um einen Schalter zur Betätigung eines Scheibenwischers handelt.
